# EUROPÄISCHE PATENTANMELDUNG

(11) **EP 0 579 855 A1**
(43) Veröffentlichungstag der Anmeldung: **26.01.1994**
(21) Anmeldenummer: 92112607.4
(22) Anmeldetag: 23.07.1992
(51) Int. Cl.: H03K 5/13

(54) **Schaltungsanordnung zur Laufzeitkompensation**

(71) Anmelder: SIEMENS AKTIENGESELLSCHAFT, D-80333 München (DE)
(72) Erfinder: Meyer, Willibald, Dipl.-Ing., W-8000 München 83 (DE)

(57) **Zusammenfassung**

Die erfindungsgemäße Schaltungsanordnung weist eine steuerbare Verzögerungsschaltung (3) auf, die in den Signalweg eines Datenkanals geschaltet wird. In Abhängigkeit von der Arbeitsgeschwindigkeit der integrierten Schaltung können entweder automatisch oder manuell die prozessbedingten Schwankungen der Arbeitsgeschwindigkeit kompensiert werden. Dies erfolgt entweder durch Ansteuerung der Verzögerungsschaltung (3) und Auswahl verschiedener Verzögerungszeiten durch eine eine elektrische oder mit Laser auftrennbare Verbindung enthaltende Anordnung (6) oder durch eine einen Laufzeitdiskriminator enthaltende Anordnung (6).

## Beschreibung

Die Erfindung betrifft eine Laufzeitdiskriminator-Schaltung gemäß dem Oberbegriff des Anspruchs 1.

Bei schnellen digitalen integrierten Halbleiterschaltungen, wie sie z.B. im Speicherbereich für Grafik- oder Videoanwendungen verwendet werden, ist es wünschenswert, eine definierte und möglichst große Haltezeit, wobei die Haltezeit diejenige Zeit ist innerhalb der Daten an einer Datenleitung stabil anliegen, für Ausgangssignale zu gewährleisten. Da die Flanken der Signale wegen Spitzenstrombedarf nicht beliebig steil gemacht werden können, besteht grundsätzlich ein Konflikt mit der üblichen Forderung nach möglichst kurzen Verzögerungszeiten, d.h. derjenigen Zeiten, die das Signal benötigt, um nach Aktivierung in einen stabilen Zustand überzugehen, für dieselben Signale. Zusätzlich schwanken die Werte der Haltezeiten und der Verzögerungszeiten von derartigen schnellen digitalen integrierten Halbleiterschaltungen aufgrund von Prozesstreuungen während der Herstellung. Üblicherweise werden dann Bausteine mit zu großen Verzögerungszeiten verworfen, während Toleranzen nach kleineren Werten hin, als die spezifizierten, für Hersteller und Kunden keinerlei Probleme darstellen. Werden bestimmte von Null verschiedene positive Haltezeiten spezifiziert, so müssen jedoch Bausteine, die sich aufgrund der Prozeßstreuungen als besonders schnelle Exemplare herausstellen, ebenfalls verworfen werden, da diese schnellen Haltezeiten von nachfolgenden Schaltungsteilen nicht mehr verarbeitet werden können.

Der vorliegenden Erfindung liegt daher die Aufgabe zugrunde, eine Schaltungsanordnung anzugeben, um dem Ausbeuteverlust bei schnellen digitalen integrierten Halbleiterschaltungen zu vermeiden.

Diese Aufgabe wird durch den kennzeichnenden Teil des Anspruchs 1 gelöst. Weiterbildungen sind Kennzeichen der Unteransprüche.

Vorteil der Erfindung ist das durch Einführen einer Verzögerungsschaltung in den Signalweg, welche verschiedene einstellbare Verzögerungszeiten aufweist, die prozeßbedingten Schwankungen derartiger schneller digitaler Halbleiterschaltungen kompensiert werden, wodurch die Ausbeute bei der Herstellung erhöht wird.

Ein weiterer Vorteil liegt in der Tatsache, daß wenn eine einfache automatische Laufzeitdiskriminator-Schaltung vorgesehen wird, die digitale steuerbare Verzögerungsschaltung auf einfache Weise automatisch an das Laufzeitverhalten der Signale angepaßt werden kann.

Die Erfindung wird nachfolgend anhand von fünf Figuren näher erläutert.

Es zeigen:
- Figur 1: eine Ausführungsform einer erfindungsgemäßen Schaltungsanordnung zur Laufzeitkompensation,
- Figur 2: eine automatische Laufzeitdiskriminator-Schaltung,
- Figur 3: eine manuelle Laufzeitdiskriminator-Schaltung,
- Figur 4: ein Beispiel für ein Laufzeitglied,
- Figur 5: ein Beispiel für eine steuerbare Verzögerungsschaltung.

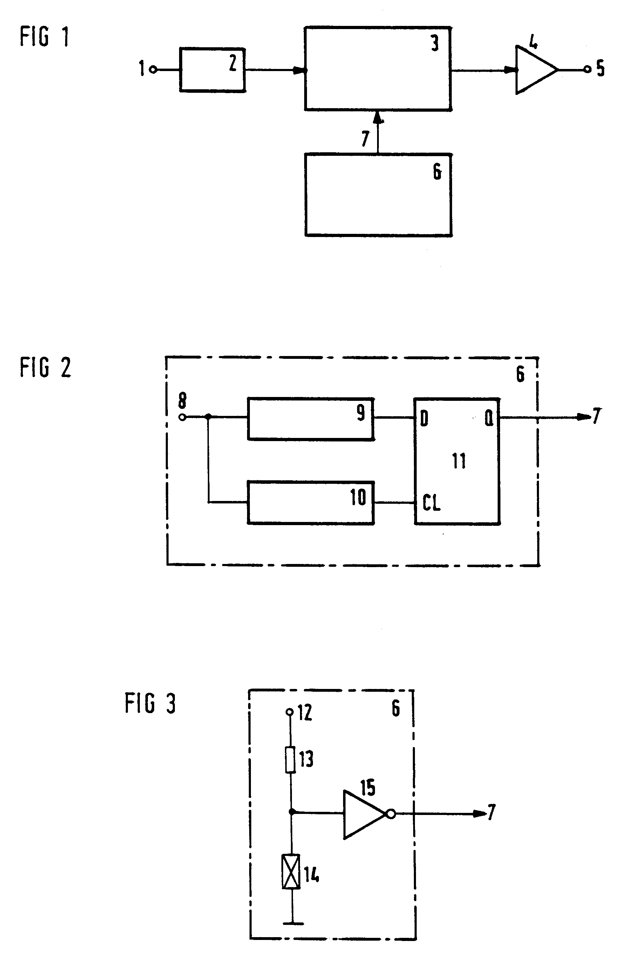

Das in Figur 1 dargestellte Blockschaltbild zeigt eine Eingangsklemme 1, an der ein Taktsignal anlegbar ist. Diese Eingangsklemme 1 ist mit einer Funktionseinheit 2 verbunden, welche ein Datensignal erzeugt. Dieses Datensignal wird dem Eingang der umschaltbaren Verzögerungsschaltung 3 zugeführt. Das Ausgangssignal der umschaltbaren Verzögerungsschaltung 3 wird über eine Treiberstufe 4 einer Ausgangsklemme 5 zugeführt. Eine Laufzeitdiskriminator-Schaltung ist mit 6 bezeichnet. Deren Ausgangssignal 7 wird dem Steuereingang der steuerbaren Verzögerungsschaltung 3 zugeführt.

Die in Figur 2 dargestellte Laufzeitdiskriminator-Schaltung 6 enthält eine Eingangsklemme 8, an der jeder beliebige periodische oder nicht-periodische Takt, wie er in digitalen integrierten Schaltungen allfällig vorhanden ist, Zugeführt werden kann. Diese Eingangsklemme 8 ist mit dem Eingang eines ersten Verzögerungsglieds 9 sowie mit dem Eingang eines zweiten Verzögerungsglieds 10 verbunden. Der Ausgang des ersten Verzögerungsglieds 9 ist mit dem Dateneingang D eines Flip-Flops 11 verbunden. Ebenso ist der Ausgang des Verzögerungsglieds 10 mit dem Takteingang CL des D-Flip-Flops 11 verschaltet. Am Ausgang Q des D-Flip-Flops 11 kann das Steuersignal 7 abgegriffen werden.

Die in Figur 3 dargestellte manuelle Laufzeitdiskriminator-Schaltung weist eine Anschlußklemme 12 auf, an der die Versorgungsspannung anliegt. Diese ist über einen Widerstand mit dem Eingang eines invertierenden Treibers 15 verbunden. Weiterhin ist eine elektrisch oder mit Laser auftrennbare Verbindung 14 vorgesehen, die den Eingang der invertierenden Treiberstufe 15 mit Messe verbindet. Am Ausgang der invertierenden Treiberstufe 15 ist wiederum das Steuersignal 7 abgreifbar.

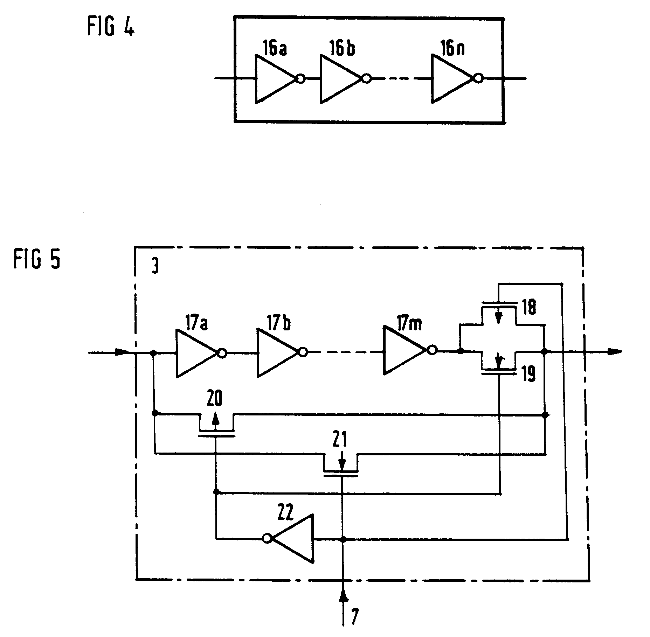

Figur 4 zeigt ein Beispiel für ein Verzögerungsglied entsprechend der in Figur 2 dargestellten Verzögerungsglieder 9 bzw. 10. Diese können aus einer Vielzahl n bestehenden Reihenschaltung von invertierenden oder auch nicht-invertierenden Treiberstufen 16a, 16b...16n bestehen. Dabei ist die Anzahl der invertierenden oder nicht-invertierenden Treiberstufen unwesentlich, wichtig ist nur, daß beide Verzögerungsglieder 9 und 10 die gleiche Anzahl von Treiberstufen aufweisen.

Die in Figur 5 dargestellte steuerbare Verzögerungsschaltung weist ebenfalls eine Vielzahl m von in Reihe geschalteten invertierenden Treiberstufen 17a, 17b...17m auf. Das Eingangssignal wird dem Eingang der ersten Treiberstufe 17a zugeführt. Ebenso gelangt das Eingangssignal über die Laststrecke eines p-Kanal-FETs 20 und über die parallel geschaltete Laststrecke eines n-Kanal-FETs 21 zum Ausgang. Der Ausgang der letzten Treiberstufe 17m ist ebenfalls über die Laststrecke eines n-Kanal-FETs 19 und über die parallel zur Laststrecke des FETs 19 geschaltete Laststrecke eines p-Kanal-FETs 18 mit dem Ausgang der steuerbaren Verzögerungsschaltung verbunden. Der Steuereingang ist mit dem Gate-Anschluß des n-Kanal-FETs 21 und des p-Kanal-FETs 18 verschaltet. Weiterhin ist eine invertierende Treiberstufe 22 vorgesehen, deren Eingang ebenfalls mit dem Steuereingang verschaltet ist. Der Ausgang der invertierenden Treiberstufe 22 ist sowohl mit dem Gate-Anschluß des p-Kanal-FETs 20 wie auch mit dem Gate-Anschluß des n-Kanal-FETs 19 verschaltet.

Über die Diskriminator-Schaltung 6 kann die digital steuerbare Verzögerungsschaltung 3 auf verschiedene Verzögerungszeiten eingestellt werden. Ist die Laufzeitdiskriminator-Schaltung gemäß Figur 3 ausgebildet, so kann nach einem Scheibentest die elektrisch oder mit Laser auftrennbare Verbindung 14 immer dann geöffnet werden, wenn die gemessenen Zeitparameter eine Korrektur der Haltezeit erforderlich machen. Der Widerstand 13 kann dabei durch jedes andere, den elektrischen Stromfluß begrenzende Bauelement, wie z.B. einen oder mehrere Transistoren, ersetzt werden. Selbstverständlich sind auch andere einfache elektrisch oder mit Laser auftrennbare Verbindungen enthaltende Logikanordnungen denkbar.

Wird eine Laufzeitdiskriminator-Schaltung gemäß Figur 2 gewählt, so kann die Verzögerungszeit der digital steuerbaren Verzögerungsschaltung automatisch an die jeweiligen Verhältnisse angepaßt werden. Der Laufzeitdiskriminator gemäß Figur 2 besteht dabei im wesentlichen aus den beiden Verzögerungsgliedern, welche unterschiedlicher Konstruktion sind, aber die gleiche Grundlaufzeit unter Nennbedingungen aufweisen. So schwanken die Verzögerungszeiten je nach herstellungsbedingten Prozesschwankungen. Für die Ansteuerung der Laufzeitglieder 9, 10 eignet sich jeder beliebige periodische oder nicht-periodische Takt, wie er in digitalen integrierten Schaltungen allfällig vorhanden ist. Da er nur eine Hilfsfunktion hat, ist seine genaue Form, zeitliche Lage, Länge etc. nicht maßgebend. Die Laufzeitglieder 9, 10 werden nun beispielsweise wie in Figur 4 dargestellt, so ausgestaltet, daß Prozesschwankungen unterschiedliche Auswirkungen auf ihre Laufzeiten haben. Dies kann unter anderem durch unterschiedliche Kanallängen und unterschiedliche Kanalweiten bei den verwendeten Transistoren der Treiberstufen 16a, 16b..16n für die jeweiligen Laufzeitglieder erreicht werden. Beispielsweise soll angenommen werden, daß das Laufzeitglied 10 bei Toleranzen, die höhere Geschwindigkeit bedingen, eine geringere Verzögerung erfährt als das Laufzeitglied 9. Dann wird das D-Flip-Flop 11 beim Auftreten eines Taktes an der Eingangsklemme 8 ein logisches Nullsignal am Ausgang U liefern und damit in der steuerbaren Verzögerungsschaltung 3 dafür sorgen, daß die längere Verzögerung in den Datenpfad eingeschleift wird. Damit wird der Geschwindigkeitsanstieg teilweise oder ganz kompensiert und die Haltezeitforderung kann problemlos erfüllt werden. Treten Toleranzen auf, die ein verringerte Geschwindigkeit bedingen, so erfährt nun das Laufzeitglied 9 eine größere Verzögerung als das Laufzeitglied 10, das D-Flip-Flop 11 liefert nun ein logisches Eins-Signal am Ausgang Q und sorgt in der steuerbaren Verzögerungsschaltung dafür, daß die kürzere Verzögerungszeit aktiviert wird. Damit wird dem Geschwindigkeitsverlust entgegengewirkt.

Wie bereits zuvor beschrieben, weist die digital steuerbare Verzögerungsschaltung in diesem Fall zwei verschiedene Datenpfade auf, die unterschiedliche Verzögerungszeiten haben. Über eine entsprechende Logik kann der Datenpfad von einem Weg zum anderen Weg umgeschaltet werden. Die Laufzeit des ersten Datenwegs sollte dabei möglichst klein und nahe bei Null liegen, um bei langsamen Schaltungen keine Probleme mit der Signalverzögerungszeit zu bekommen. Selbstverständlich könnten bei entsprechender Auslegung der Laufzeitdiskriminator-Schaltung auch mehrere umschaltbare Datenpfade mit verschiedenen Laufzeiten in der steuerbaren Verzögerungsschaltung 3 vorgesehen werden.

In einer schnellen digitalen integrierten Halbleiterschaltung kann die die Schaltungsteile 9, 10, 11 enthaltende Laufzeitdiskriminator-Schaltung zentral aufgebaut werden, während für jeden Ausgangsdatenpfad getrennt eine digital steuerbare Verzögerungsleitung erforderlich ist.

Insgesamt ermöglicht es die erfindungsgemäße Schaltungsanordnung, anwenderfreundliche Haltezeiten zu garantieren und dabei größere Meß- und Prozeßtoleranzen zuzulassen, ohne die Gesamtverzögerungszeiten wesentlich zu verschlechtern.

Figur 5 zeigt eine einfache Ausführungsform für eine steuerbare Verzögerungsschaltung mit zwei Datenpfaden unterschiedlicher Laufzeit. Liegt am Steuereingang ein logisches Nullsignal an, so werden die FETs 20, 21 gesperrt und die FETs 18 und 19 in den leitenden Zustand geschaltet. Dadurch ergibt sich der Datenpfad der über die m-Inverterstufen 17a, 17b...17m und die Laststrecken der beiden FETs 18 und 19 erfolgt. Liegt dagegen an Steuereingang 7 ein logisches Eins-Signal an, so werden die FETs 18 und 19 gesperrt. Dadurch wird der Datenpfad zwischen Ein- und Ausgang der Verzögerungsschaltung über die FETs 20 und 21 kurzgeschlossen und somit stellt sich eine Verzögerungszeit, die nahe bei Null liegt, ein.

## Patentansprüche

1. Schaltungsanordnung zur Laufzeitkompensation für schnelle digitale Halbleiterschaltungen mit einer Signalquelle (2) und einer Signalsenke (4, 5),
**dadurch gekennzeichnet,**
daß die Schaltungsanordnung eine steuerbare Verzögerungsschaltung aufweist, die zwischen Signalquelle (2) und Signalsenke (4, 5) geschaltet ist, wobei in der Verzögerungschaltung in Abhängigkeit von einem Steuersignal (7) mindestens zwei verschiedene Verzögerungszeiten schaltbar sind und eine Steuerschaltung zur Umschaltung zwischen den verschiedenen Verzögerungszeiten in Abhängigkeit von herstellungsbedingten Schwankungen der Arbeitsgeschwindigkeit der digitalen Halbleiterschaltung vorgesehen ist.

2. Schaltungsanordnung nach Anspruch 1,
**dadurch gekennzeichnet,**
daß die Steuerschaltung wenigstens eine elektrische oder mit Laser auftrennbare Verbindung aufweist, durch welche die Umschaltung der Verzögerungszeiten gesteuert wird.

3. Schaltungsanordnung nach Anspruch 1,
**dadurch gekennzeichnet,**
daß die Steuerschaltung Mittel enthält, die die herstellungsbedingten Schwankungen der Arbeitsgeschwindigkeit der digitalen Halbleiterschaltung ermittelt und in Abhängigkeit des so ermittelten Werts die Verzögerungszeit der Verzögerungsschaltung einstellt.

4. Schaltungsanordnung nach Anspruch 3,
**dadurch gekennzeichnet,**
daß die Mittel wenigstens zwei Laufzeitglieder mit gleicher Laufzeit aufweist, daß die Laufzeitglieder derart gestaltet sind, daß die herstellungsbedingten Schwankungen unterschiedliche Laufzeitschwankungen erwirken, daß eine Auswerteschaltung vorgesehen, die die Laufzeitunterschiede der Laufzeitglieder ermittelt und abhängig davon die Verzögerungszeit der Verzögerungsschaltung einstellt.

5. Schaltungsanordnung nach Anspruch 4,
**dadurch gekennzeichnet,**
daß die Laufzeitglieder Feldeffektransistoren enthalten, daß die Kanallänge und Kanalweite der Feldeffektransistoren eines Laufzeitglieds unterschiedlich zu denen der anderen Laufzeitglieder ist.

6. Schaltungsanordnung nach Anspruch 5,
**dadurch gekennzeichnet,**
daß die Mittel zwei Laufzeitglieder aufweisen, die von einem Taktsignal gespeist werden, daß ein D-Flip-Flop vorgesehen ist, daß der Ausgang des ersten Laufzeitglieds mit dem Dateneingang des D-Flip-Flops und der Ausgang des zweiten Laufzeitglieds mit dem Takteingang des D-Flip-Flops verbunden ist, daß die Verzögerungsschaltung einen Steuereingang aufweist und in Abhängigkeit eines am Steuereingang anliegenden logischen Signals zwischen zwei Verzögerungszeiten umgeschaltet wird, daß der Ausgang des D-Flip-Flops mit dem Steuereingang der Verzögerungsschaltung verbunden ist.

7. Schaltungsanordnung nach Anspruch 6,
**dadurch gekennzeichnet,**
daß die steuerbare Verzögerungsschaltung, m-Treiberstufen (17a, 17b...17m) sowie zwei n-Kanal-FETs und zwei p-Kanal-FETs und einen Inverter (22) aufweist, wobei der Eingang über eine Reihenschaltung der m-Treiberstufen und der Parallelschaltung der Laststrecken eines n-Kanal-FETs und eines p-Kanal-FETs mit dem Ausgang verbunden ist, wobei die Laststrecken des zweiten p-Kanal-FETs und des zweiten n-Kanal-FETs parallel geschaltet sind und den Ein- und Ausgang der Verzögerungsschaltung kurzschließen und wobei das Steuersignal dem ersten p-Kanal-FET und dem zweiten n-Kanal-FET sowie dem Inverter zugeführt wird, und daß der Ausgang des Inverters mit dem Gate-Anschluß des ersten n-Kanal-FETs und des zweiten p-Kanal-FETs verbunden ist.

8. Schaltungsanordnung nach einem der Ansprüche 4 bis 7,
**dadurch gekennzeichnet,**
daß jedes Laufzeitglied eine Vielzahl von invertierenden oder nicht-invertierenden Treiberstufen aufweist.

9. Schaltungsanordnung nach Anspruch 2,
**dadurch gekennzeichnet,**
daß die Steuerschaltung (6) eine Versorgungsspannungsklemme (12) aufweist, die über einen Widerstand (13) mit dem Eingang eines Inverters (15) verbunden ist, daß der Eingang der Inverterstufe (15) über eine elektrisch oder mit Laser auftrennbare Verbindung mit Masse verbunden ist und das Ausgangssignal am Ausgang des Inverters (15) abgreifbar ist.
